Europäisches Patentamt

(19) European Patent Office

Office européen des brevets

(11) Numéro de publication: **0 179 714
B1**

(12) **FASCICULE DE BREVET EUROPEEN**

(45) Date de publication du fascicule du brevet:
**18.01.89**

(21) Numéro de dépôt: **85402004.7**

(22) Date de dépôt: **16.10.85**

(51) Int. Cl.⁴: **H 01 L 25/04**

54 **Procédé de montage de deux composants semiconducteurs dans un boîtier commun, et dispositif obtenu par ce procédé.**

(30) Priorité: **16.10.84 FR 8415817**

(43) Date de publication de la demande:
**30.04.86 Bulletin 86/18**

(45) Mention de la délivrance du brevet:
**18.01.89 Bulletin 89/3**

(84) Etats contractants désignés:
**CH DE GB IT LI NL**

(56) Documents cités:
**EP-A- 0 072 545
DE-A- 2 510 982
DE-A- 3 336 979**

(73) Titulaire: **THOMSON-CSF, 173, Boulevard Haussmann,
F-75379 Paris Cédex 08 (FR)**

(72) Inventeur: **Daubresse, Francis, THOMSON-CSF
SCPI 173, bld Haussmann, F-75379 Paris Cedex 08 (FR)**

(74) Mandataire: **Rinuy, Santarelli et al, 14, avenue de la
Grande Armée, F-75017 Paris (FR)**

ACTORUM AG

## Description

L'invention concerne un procédé et un dispositif de montage de deux composants semi-conducteurs dans un boîtier commun. Elle s'applique plus particulièrement au domaine des semi-conducteurs de puissance utilisables en commutation: thyristors, triacs ou transistors de puissance.

Il est connu des circuits électroniques, en particulier celui associant un triac à un diac, dans lesquels deux composants sont toujours connectés l'un à l'autre selon un même schéma de montage. Pour diverses raisons il n'est pas forcément possible d'intégrer les deux composants sur un même substrat semi-conducteur. Chacun d'eux est alors fabriqué séparément puis encapsulé dans un boîtier propre. Dans un circuit électronique réalisé chacun de ces deux composants doit alors être enfiché à son tour. Le doublement des opérations d'enfichage et une perte de temps voire de place si l'implantation des composants est délicate.

Chacun des composants semi-conducteurs étant élaboré à partir de pastilles semi-conductrices différentes il a été envisagé d'incorporer les deux pastilles dans un boîtier commun. Or les deux composants associés, par exemple un triac et un diac, sont rarement de taille comparable. La manipulation de plus petit d'entre eux pour l'approcher du dispositif de connexion du plus grand est délicate. Par ailleurs, pour limiter le rejet de l'ensemble il faut trier les pastilles pour éliminer celles qui sont défectueuses. Ce tri, qui est un tri électrique, est d'autant plus difficile à réaliser que les pastilles sont petites, ceci pour des raisons de difficulté de manipulation. Enfin une pastille n'étant pas protégée ses connexions directes dans le boîtier d'une autre pastille entraînent une baisse non négligeable du rendement d'assemblage: les petites pastilles se dégradent. La solution qui consiste à agrandir la petite pastille pour qu'elle soit plus facilement manipulable n'est pas économique. Elle entraîne inutilement une augmentation de la consommation de matériau semi-conducteur.

La présente invention a pour objet de remédier aux inconvénients cités en associant, au cours du montage, non pas deux pastilles semi-conductrices, mais une pastille semi-conductrice et un composant entier y compris son boîtier. Le composant entier est celui qui correspond à la pastille de petite taille. Ces deux éléments sont alors insérés dans le boîtier qui étant auparavant réservé à la grande pastille semi-conductrice seule.

L'invention concerne un procédé et/ou un dispositif de montage de deux composants semi-conducteurs dans un boîtier commun, ce boîtier commun ayant au moins deux broches de connexion de sortie, dont une première est reliée électriquement à une face arrière d'une première pastille semi-conductrice pour former un premier composant, cette première pastille comportant par ailleurs au moins une première zone métallisée sur sa face avant, caractérisé en ce que le deuxième composant est constitué par une pastille semi-conductrice encapsulée dans un boîtier fermé pourvu de deux électrodes de sortie, et en ce que l'une de ces électrodes est soudée à ladite première zone métallisée tandis que l'autre est soudée à la deuxième broche de connexion.

L'invention sera mieux comprise à la lecture de la description qui suit et à l'examen des figures qui l'accompagnent. Celles-ci ne sont données ici qu'à titre indicatif et nullement limitatif de l'invention. En particulier elles ne sauraient limiter l'invention à l'application triac-diac qui y est représentée. Elles montrent:

fig. 1 un exemple d'utilisation d'un montage conforme à l'invention;

fig. 2 la réalisation technologique du montage de l'invention.

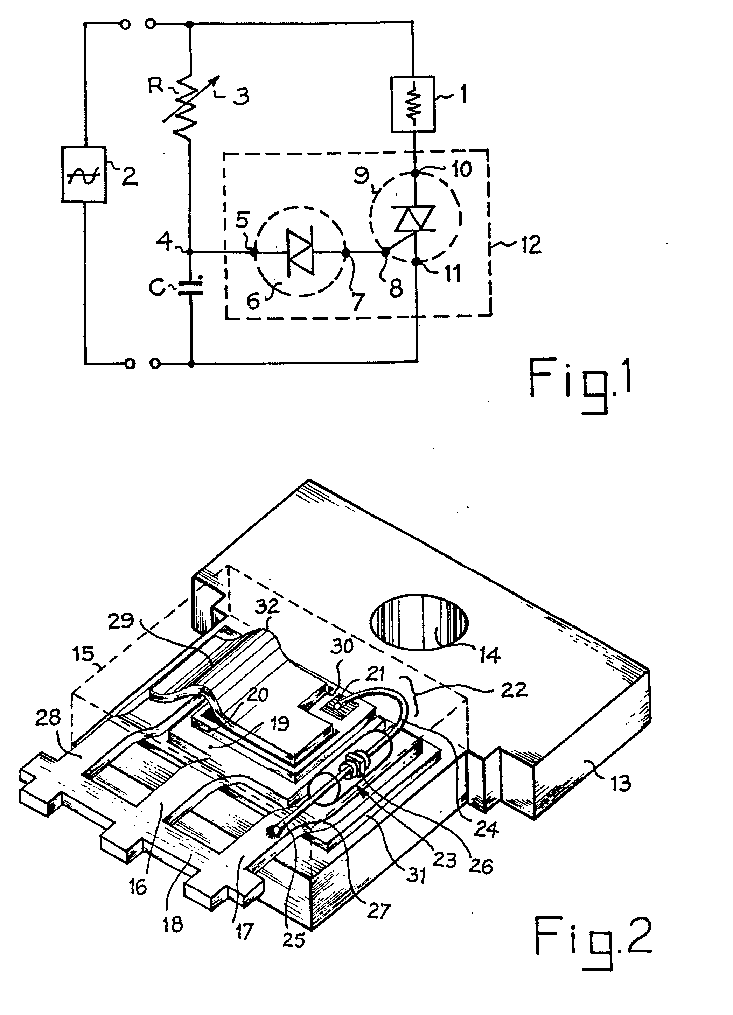

La fig. 1 représente un circuit électronique dans lequel une charge 1 est alimentée électriquement par un générateur de courant alternatif 2. Pour limiter la quantité d'énergie qui est débitée dans la charge on agit par un réglage 3 sur la constante de temps d'un dipôle R–C. Le point milieu 4 de ce dipôle est relié à une première électrode 5 d'un diac 6. L'autre électrode 7 de ce diac est reliée à une électrode de gâchette 8 d'un triac 9. Ce triac 9 est monté en série avec la charge 1. Le triac et la charge sont montés en parallèle, d'une part avec le dipôle R–C, et d'autre part avec le générateur 2. Le triac est raccordé à la charge 1 par une première électrode principale 10 et il est relié au générateur 2 par sa deuxième électrode principale 11. Le circuit représenté sur la fig. 1 est très utilisé pour régler la vitesse de moteurs à courant alternatif. Ce que ce circuit a de remarquable c'est qu'il comporte un montage 12 de deux composants semi-conducteurs qui sont toujours raccordés comme le montre la figure: à savoir que l'électrode 7 du diac 6 est toujours raccordée à la gâchette 8 du triac 9. Il est donc utile d'effectuer leur montage dans un même boîtier.

La fig. 2 représente le montage de deux composants semi-conducteurs dans un boîtier commun selon l'invention. Le boîtier comporte une embase 13 qui sert de radiateur. Elle est éventuellement accolable à un radiateur plus gros par fixation par vis dans une ouverture circulaire 14. Les composants sont disposés sur l'embase comme on le décrira plus loin et sont noyés dans une résine d'encapsulation 15 thermodurcissable. Pour la simplicité de la représentation, on a seulement représenté le contour de cette résine (en traits tiretés). Le boîtier 13–15 comporte au moins deux broches de connexions de sortie: les broches 16 et 17. Lors de l'insertion des composants ou des pastilles, pour plus de facilité de manipulation, ces broches sont réunies mécaniquement entre elles par des entretoises telles que 18. Après complète fabrication ces entretoises sont découpées pour redonner leur indépendance électrique aux broches. Une première broche 16 comporte une plaque 19 qui est reliée électriquement à une face arrière (ici invisible) d'une première pastille semi-conductrice 20. La pastille 20 dans l'exemple représenté correspond au triac 9. La face arrière représente une première électrode de ce triac. Cette pastille 20 comporte par ailleurs au moins une première zone métallisée 21 sur sa face avant (ici, la gâchette du triac).

Ce qui caractérise l'invention est que le deuxième composant semi-conducteur 22 est constitué par une pastille semi-conductrice 26 qui est encapsulée dans un boîtier fermé 23. Le boîtier 23 est représenté en éclaté. La pastille 26 correspond au diac 6. Ce boîtier comporte deux électrodes de sortie: les électrodes 24 et 25. Une de ces électrodes, l'électrode 24, est soudée à la première zone métallisée 21 tandis que l'autre électrode 25, est soudée à la deuxième broche de connexion 17 du boîtier 13–15.

Le problème le plus important que permet de résoudre l'invention est celui de l'assemblage des deux composants semi-conducteurs. En effet, autant la pastille semi-conductrice 20 est de dimension appréciable, autant la pastille semi-conductrice 26 est de petite taille. Elle est d'ailleurs d'autant plus de petite taille que la fonction électronique qu'elle exécute, la fonction d'un diac, peut être réalisée en ne mettant en œuvre qu'une petite surface de matériau semi-conducteur. Dans un exemple le côté de la pastille semi-conductrice 26 vaut environ 0,5 millimètre. Pour que la pastille 26 soit aisément manipulable il faudrait qu'elle mesure au moins 1,25 millimètre de côté. Le composant entier présente lui par contre l'avantage d'être beaucoup plus grand et notamment de posséder déjà deux électrodes de sortie 24 et 25.

Quand le composant 22 n'est pas présent dans le boîtier 13–15 la zone métallisée 21 est reliée à la broche 17 par un pontet conducteur. Une deuxième idée de l'invention consiste alors à remplacer ce pontet par le composant 22. En effet la mise en place des pontets est délicate: elle entraîne des précautions de manipulation; ces précautions sont maintenant mises à profit pour remplacer le pontet par le composant 22. Sur le plan pratique le composant 22 étant tellement petit (boîtier normalisé DO-35) il prend la même place qu'un pontet. Dans tous les cas il s'insère facilement dans le boîtier du triac (boîtier normalisé TO-220) par exemple.

Le boîtier 23 du composant 22 a une forme cylindrique. Les électrodes 24 et 25 en sortent sensiblement dans l'axe. C'est-à-dire qu'elles sont décalées en attitude par rapport aux génératrices extérieures du boîtier 23. Ce décalage d'altitude est mis à profit pour raccorder simplement l'électrode 24 à la zone métallisée 21. En effet le boîtier 23 repose sur l'extrémité de la broche 17 comme la pastille 20 repose sur la plaque 19. La plaque 19 et l'extrémité de la broche 17 sont sensiblement dans un même plan. Le décalage d'altitude entre l'électrode 24 et la base du boîtier 23 correspond alors sensiblement à l'épaisseur de la pastille semi-conductrice 20. En conséquence il suffit simplement de courber en forme de crosse l'électrode 24 pour qu'elle vienne s'appliquer sur la première zone métallisée 21. L'extrémité de cette crosse y est soudée. D'autre part, pour rattraper ce décalage les broches du boîtier 13–15 comportent une chambre 27 forme de lettre en «S». L'effet de cette cambrure est d'amener la face supérieure de la broche 17 à peu près à la hauteur de l'autre électrode 25 du composant 22. Les soudures des deux électrodes du composant 22 peuvent alors être entreprises simplement. Elles sont tout à fait comparable aux soudures qui étaient effectuées avec des pontets dans l'état de la technique. Il résulte de tout ceci que le procédé de montage du composant 22 dans le boîtier 13–15 s'effectue dans aucune opération supplémentaire.

Dans l'exemple représenté le premier composant semi-conducteur est un triac. Le boîtier 13–15 comporte donc une troisième broche 28 pour venir se connecter par l'intermédiaire d'une pontet conducteur (feuille métallique de contact) 29 à une deuxième zone métallisée 30. Cette deuxième zone 30 est également située sur la face avant de la pastille 20 à côté de la première zone 21. Cette première zone métallisée 21 constitue l'accès de gâchette du triac; la deuxième zone métallisée en face avant correspond à la deuxième électrode de ce triac. La fig. 2 montre encore que toute la structure réalisée est un empilage. Au-dessus de l'embase 13 est disposée une plaque en céramique 31 possédant la particularité d'être bonne conductrice de la chaleur tout en étant isolante électriquement. Au-dessus de la plaque 31 sont placées, en contact avec cette plaque 31, les trois broches 16, 17 et 28 du triac. La première pastille semi-conductrice 20 surmontée de la feuille métallique 29 est placée au-dessus de la plaque 19 de l'électrode centrale 16. Une extrémité de cette feuille métallique 29 déborde hors de la surface métallisée 30; après une ondulation 32 pour rattraper le décalage d'altitude cette feuille vient se connecter sur l'électrode 28. Du côté opposé à l'électrode 28 par rapport à l'électrode 16 est disposée l'électrode 17. Au-dessus de celle-ci le composant semi-conducteur 22 est placé comme cela a été indiqué plus haut.

Le montage selon l'invention peut être adapté à d'autres circuits que ceux comportant un diac et un triac. Par exemple il peut être adapté à ceux comportant un thyristor et de sa diode de destockage. Le procédé de montage de l'invention est plus particulièrement réalisable lorsque la première zone métallisée se trouve à la périphérie de la face avant de la première pastille semi-conductrice. On peut cependant imaginer qu'il est réalisable même si cette première zone métallisée était disposée centralement à l'intérieur d'une deuxième zone métallisée annulaire.

En effet le deuxième composant étant utilisé en lieu et place d'un pontet rien se s'oppose à ce qu'il soit connecté à une surface centrale.

## Revendications

1. Procédé de montage de deux composants (9, 6) semi-conducteurs dans un boîtier commun (13–15), ce boîtier commun ayant au moins deux broches (16, 17) de connexion de sortie dont une première (16) est reliée électriquement à une face arrière d'une première pastille semi-conductrice (20) pour former un premier composant (9), cette première pastille comportant par ailleurs au moins une première zone métallisée (21) sur sa face avant, caractérisé en ce que le deuxième composant (22) est constitué par une pastille semi-conductrice (26) encapsulée dans un boîtier (23) fermé pourvu de deux électrodes (24, 25) de sortie et en ce que l'une de ces électrodes (24) est soudée à ladite zone métallisée tandis que l'autre (25) est soudée à la deuxième broche (17) de connexion.

2. Procédé selon la revendication 1, caractérisé en ce que l'on réalise une cambrure (27) dans les broches.

3. Procédé selon l'une quelconque des revendictions 1 à 2, caractérisé en ce que le deuxième composant (22) est déposé sur une broche, sensiblement à la même hauteur que la première pastille semi-conductrice sur une autre broche.

4. Procédé selon l'une quelconque des revendications 1 à 3, caractérisé en ce que le premier composant est un triac, le deuxième composant un diac, et en ce que le boîtier commun (13–15) possède trois broches (16, 17, 28), la troisième broche (28) étant reliée à une deuxième zone métallisée (30) sur la face avant du premier composant.

5. Composant électronique incorporant deux composants semi-conducteurs (9, 6) dans un boîtier (13–15) commun, ce boîtier commun ayant au moins deux broches (16, 17) de connexion de sortie dont une première (16) est reliée électriquement à une face arrière d'une première pastille semi-conductrice (20) pour former un premier composant (9), cette première pastille comportant par ailleurs au moins une première zone métallisée (21) sur sa face avant caractérisé en ce que le deuxième composant (22) est constitué par une pastille semi-conductrice (26) encapsulée dans un boîtier (23) fermé pourvu de deux électrodes (24, 25) de sortie et en ce que l'une de ces électrodes (24) est soudée à ladite zone métallisée tandis que l'autre (25) est soudée à la deuxième broche (17) de connexion.

6. Composant selon la revendication 5, caractérisé en ce que la première zone métallisée est disposée à la périphérie de la face avant de la première pastille.

## Patentansprüche

1. Verfahren zum Montieren zweier Halbleiterbauelemente (9, 6) in einem gemeinsamen Gehäuse (13–15), das wenigstens zwei Ausgangs-Anschlussstege (16, 17) aufweist, von denen ein erster (16) elektrisch an eine Rückseite eines ersten Halbleiterplättchens (20) zur Ausbildung eines ersten Bauelementes (9) angeschlossen ist, wobei dieses erste Plättchen daneben wenigstens einen ersten metallbeschichteten Bereich (21) auf seiner Vorderseite aufweist, dadurch gekennzeichnet, dass das zweite Bauelement (22) von einem Halbleiterplättchen (26) gebildet wird, das in einem mit zwei Ausgangselektroden (24, 25) versehenen geschlossenen Gehäuse (23) eingekapselt ist, und dass die eine dieser Elektroden (24) an dem metallbeschichteten Bereich und die andere (25) an dem zweiten Anschlusssteg (17) angelötet ist.

2. Verfahren nach Anspruch 1, dadurch gekennzeichnet, dass an den Stegen eine Krümmung (27) ausgebildet wird.

3. Verfahren nach einem der Ansprüche 1 bis 2, dadurch gekennzeichnet, dass das zweite Bauelement (22) auf einen Steg aufgebracht ist, und zwar genau in derselben Höhe wie das erste Halbleiterplättchen auf einem anderen Steg.

4. Verfahren nach einem der Ansprüche 1 bis 3, dadurch gekennzeichnet, dass das erste Bauelement ein Triac und das zweite Bauelement ein Diac ist und dass das gemeinsame Gehäuse (13–15) drei Stege (16, 17, 28) aufweist, wobei der dritte Steg (28) an einen zweiten metallbeschichteten Bereich (30) auf der Vorderseite des ersten Bauelementes angeschlossen ist.

5. Elektronisches Bauelement, das zwei Halbleiterbauelemente (9, 6) in einem gemeinsamen Gehäuse (13–15) umfasst, wobei das gemeinsame Gehäuse wenigstens zwei Ausgangs-Anschlussstege (16, 17) aufweist, von denen ein erster (16) elektrisch an eine Rückseite eines ersten Halbleiterplättchens (20) zur Ausbildung eines ersten Bauelementes (9) angeschlossen ist, wobei dieses erste Plättchen daneben wenigstens einen ersten metallbeschichteten Bereich (21) auf seiner Vorderseite aufweist, dadurch gekennzeichnet, dass das zweite Bauelement (22) von einem Halbleiterplättchen (26) gebildet wird, das in einem mit zwei Ausgangselektroden (24, 25) versehenen geschlossenen Gehäuse (23) eingekapselt ist, und dass die eine dieser Elektroden (24) an dem metallbeschichteten Bereich und die andere (25) an den zweiten Anschlusssteg (17) angelötet ist.

6. Bauelement nach Anspruch 5, dadurch gekennzeichnet, dass der erste metallbeschichtete Bereich an der Peripherie der Vorderseite des ersten Plättchens vorgesehen ist.

## Claims

1. A process for mounting two semiconductor components (9, 6) in a common casing (13–15), this common casing having at least two output connecting pins (16, 17) a first one of which (16) is electrically connected to a rear face of a first semiconducting chip (20) to form a first component (9), this first chip also comprising at least one first metallized zone (21) on its front face, characterized in that the second component (22) is constituted by a semiconducting chip (26) encapsulated in a closed casing (23) provided with two output electrodes (24, 25) and in that one of these electrodes (24) is soldered to the said metallized zone whereas the other (25) is soldered to the second connecting pin (17).

2. A process according to claim 1, characterized in that a bend (27) is made in the pins.

3. A process according to any one of claims 1 to 2, characterized in that the second component (22) is deposited on a pin substantially at the same height as the first semiconducting chip on another pin.

4. A process according to any one of claims 1 to 3, characterized in that the first component is a triac, the second component a diac, and in that the common casing (13–15) comprises three pins (16, 17, 28), the third pin (28) being joined to a second metallized zone (30) on the front face of the first component.

5. An electronic component incorporating two semiconductor components (9, 6) in a common casing (13–15), the common casing having at least two output connecting pins (16, 17) of which a first (16) is electrically connected to a rear face of a first semiconducting chip (20) to form a first component (9), this first chip also comprising at least one first metallized zone (21) on its front face, characterized in that the second component (22) is constituted by a semiconducting chip (26) encapsulated in a closed casing (23) provided with two output electrodes (24, 25) and in that one of these electrodes (24) is soldered to the said metallized zone whereas the other (25) is soldered to the second connecting pin (17).

6. A component according to claim 5, characterized in that the first metallized zone is disposed on thé periphery of the front face of the first disc.

Fig.1

Fig.2